Europäisches Patentamt

European Patent Office

Office européen des brevets

(11) Publication number: **0 304 068 B1**

## EUROPEAN PATENT SPECIFICATION

(45) Date of publication of patent specification: **30.12.92**

(51) Int. Cl.5: **C23F 1/12**, G03F 7/26, C23F 1/02, H01L 21/306, H01L 21/465

(21) Application number: **88113456.3**

(22) Date of filing: **18.08.88**

(54) **Removing resist layers.**

(30) Priority: **19.08.87 JP 203986/87**

(43) Date of publication of application:
**22.02.89 Bulletin 89/08**

(45) Publication of the grant of the patent:
**30.12.92 Bulletin 92/53**

(84) Designated Contracting States:
**DE FR GB**

(56) References cited:
**EP-A- 0 067 066**
**EP-A- 0 151 408**

(73) Proprietor: **FUJITSU LIMITED**
**1015, Kamikodanaka Nakahara-ku**
**Kawasaki-shi Kanagawa 211(JP)**

(72) Inventor: **Fujimura, Shuzo c/o FUJITSU LIMIT-ED**
**Patent Department 1015 Kamikodanaka**
**Nakahara-ku**
**Kawasaki-shi Kanagawa 211(JP)**
Inventor: **Konno, Junichi c/o FUJITSU LIMITED**
**Patent Department 1015 Kamikodanaka**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

Rank Xerox (UK) Business Services

## Description

The present invention relates to a method of fabricating a semiconductor device and is particularly concerned with the removal of a resist layer which has a high dose of ions implanted therein, formed on a substrate in the course of fabrication of a semiconductor device.

Generally, in an ion implantation process used in the course of fabrication of a semiconductor device on a substrate, a resist layer made of resin such as novolak resin is used as a mask for masking designated portions of the substrate which are not to be ion-implanted, and the resist layer must be removed after the ion implantation process is finished, for proceeding to a next semiconductor device fabrication step. For removing the resist layer, an oxygen plasma etching method performed with no sputtering action, a downstream ashing method carried out in a reactive gas of hydrogen, or a wet stripping method have been used. However, when high doses of ions, for example more than $1 \times 10^{14}/cm^2$, are implanted, high doses of ions are also implanted into the resist layer, so that designated regions of the upper surface of the resist layer become physically and chemically rigid. This phenomenon is called "carbonization" and the designated region is called a "carbonized region". This carbonization of the resist layer is discussed in a paper entitled "Study on Ashing Process for Removal of Ion Implanted Resist Layer" by five authors including Shuzo Fujimura and Junichi Konno who are inventors of the present invention, in proceedings of the "DRY PROCESS" symposium, published by Electronics and Dielectrics and Insulation Divisions of The Electrochemical Society, in 1987.

Because the resist layer is carbonized, it is difficult to remove by the methods mentioned above without damaging the substrate under the resist layer. That is, if a reactive etching method such as an oxygen plasma etching method is used for removing the resist layer with a strong sputtering action, for example, by using a parallel plate plasma etching appratus, the resist layer can be ashed even though the resist layer has been carbonized. However, when such a strong sputtering is performed on the resist layer, the following problems occur:- one problem is that a surface of the substrate which was beneath the resist layer is contaminated by residues such as phosphorus pentaoxide ($P_2O_5$) and heavy metal compounds produced from the resist layer during the strong sputtering; another problem is that lattice defects are generated in a surface region of the substrate by the strong sputtering. Therefore, after removing the resist layer, residues remaining on the substrate must be selectively etched and the etched substrate must be annealed for reforming (removing) the lattice defects. Moreover, there is a further problem in that a designated portion, such as a gate oxide layer of an MOS transistor, previously fabricated in a surface region of the substrate under the resist layer, can be broken or damaged because of stored charge produced on the surface of the substrate during the plasma sputtering. If this occurs, there is no way to rectify the damage.

Thus, when high doses of ions were implanted, removal of the resist layer involves the performance of many extra processes and sometimes a previously fabricated portion of the substrate under the resist layer is damaged. The consequences are:- increased semiconductor device cost; decreased semiconductor device yield rate; decreased reliability; and restricted freedom for designing a semiconductor device.

According to the present invention there is provided a method of removing a resist layer formed on a substrate, the resist layer including an ion-implanted region, extending into the resist layer from an upper surface of the resist layer, into which a high dose of ions has been implanted and which has suffered carbonisation, the method comprising:-

removing a first region of the resist layer, including the said ion-implanted region which has suffered carbonisation, by a first plasma etching process, using hydrogen as a reactive gas, the hydrogen reacting with the dopant implanted in the resist layer, producing volatile hydrogenated compounds, leaving a second region of the resist layer in place, which second region has not suffered carbonization; and

removing the second region by a second etching process performed without using a plasma having charged particles.

An embodiment of the present invention can provide for the removal of a resist layer, into which a high dose of ions has been implanted, formed on a substrate being processed to form a semiconductor device, with simple removal processes.

An embodiment of the present invention can provide for removal of the resist layer without damage to the substrate.

Use of an embodiment of the present invention can lead to a decrease in the cost of a semiconductor device fabricated using processes involving implanting high doses of ions.

Use of an embodiment of the present invention can provide increased reliability of semiconductor devices fabricated using processes involving implanting high doses of ions.

Use of an embodiment of the present invention can provide for increased yield rate of products using semiconductor devices fabricated using processes involving implanting high doses of ions.

In an embodiment of the present invention, a resist layer is removed in the following two steps, the resist layer being divided into two regions with an upper region including a carbonized region and a lower region attached to a substrate: a step for removing the upper region by a plasma etching method carried out with a mixing gas of nitrogen and an active gas of hydrogen and a step for removing the lower region by using a previously proposed method such as a downstream sputtering method or wet stripping method.

In other embodiments other inert gases may be used as mixing gases.

Applying the plasma etching method to the upper region with the mixing gas, bonds tightly bounding the implant with carbon in the carbonized region, for example, phosphorus-carbon (P-C) bonds can be broken and an implant hydride produced, and the implant hydride is volatilized at room temperature. In the above steps, the volatilization is important for providing that almost no residue remains on the substrate after removal of the resist layer, and furthermore, the fact that the volatilization can be performed at room temperature is effective to make simple the processes involved in removal and arising after removal of the resist. Applying an embodiment of the present invention, semiconductor device cost can be decreased, yield rate can be increased, reliability of the products of the semiconductor device can be increased, and a semiconductor device can be designed without considering the problems linked with high-dose ion implantation.

Reference is made, by way of example, to the accompanying drawings, in which:-

Fig. 1(a) is a partial cross-sectional view of a silicon substrate having oxide films formed in a surface region thereof, on which a resist layer is coated, illustrating a selective phosphorus ion implantation;

Fig. 1(b) is a partial cross-sectional view of the silicon substrate coated with the resist layer, illustrating a carbonized region formed in a surface region of the resist layer due to high-dose implantation of phosphorus ions into the resist layer;

Fig. 1(c) is a partial cross-sectional view of the silicon subsrate illustrating etching of an upper region, including the carbonized region, of the resist layer by a plasma etching method;

Fig. 1(d) is a partial cross-sectional view of the silicon substrate illustrating removal of a lower region of the resist layer by a downstream ashing method; and

Fig. 2 is a schematic diagram of an etching apparatus used in an ashing process, embodying the present invention, for the resist layer.

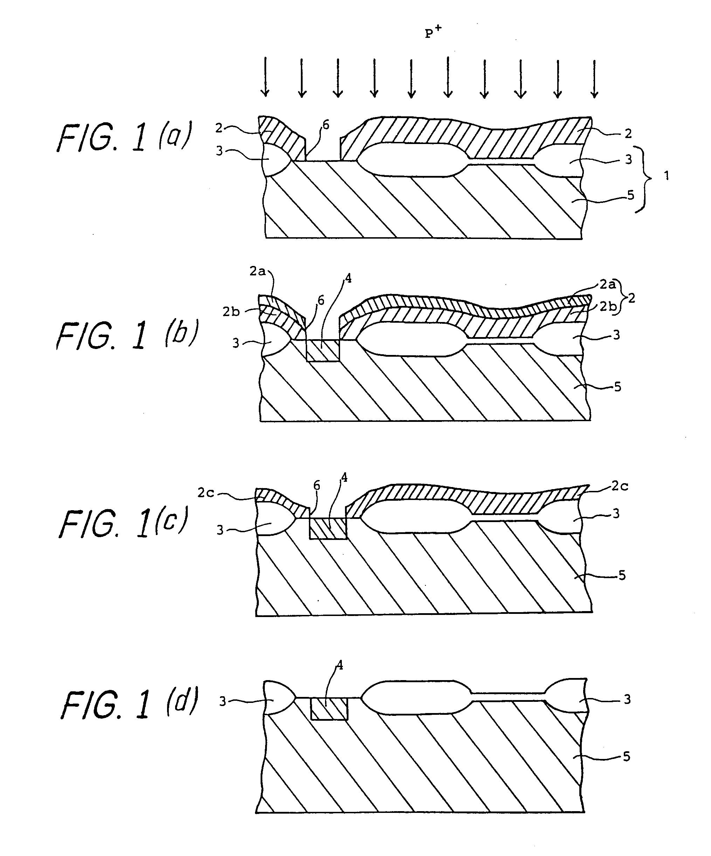

An embodiment of the present invention will be described with reference to Figs. 1(a) to 1(d) in which the cross-sectional views of a semi-processed semiconductor device illustrate successive steps in a method embodying the present invention.

In Fig. 1(a), photoresist (for example, HPR 204; FUJI-HUNT) mainly made of novolak resin, is coated on a substrate 1 by a spinner so as to form a resist layer 2 of 2 $\mu$m thickness, and the resist layer is patterned by photolithography for forming an opening 6 for implantation of a high dose of ions into a silicon substrate 5. In this embodiment, the substrate 1 consists of a silicon substrate 5 and oxide layers 3 formed in surface regions of the silicon substrate 5.

In Fig. 1(b), high doses, $1 \times 10^{16}$ cm$^{-2}$ for instance, of phosphorus ions are implanted into the silicon substrate 5 at an energy of 70 keV (kilo electron volts), to form phosphorus implanted region 4 in the silicon substrate 5 at the opening 6 in the resist layer 2. Only one opening 6 is shown in Figs. 1(a) to 1(d) and only the implanted region 4 is indicated in Figs. 1(b) to 1(d), at the opening 6. Of course, in practice, there may be a plurality of openings and implanted regions. When high-dose phosphorus ions are thus implanted into the silicon substrate 5, high-dose phosphorus ions are also implanted into the resist layer 2, which results in the production of a carbonized region 2a in the layer, leaving an uncarbonized region 2b, as shown in Fig. 1(b). In this case, the thickness of the carbonized region 2a is from 0.2 $\mu$m to 0.3 $\mu$m. This carbonized region 2a is responsible for problems as mentioned above.

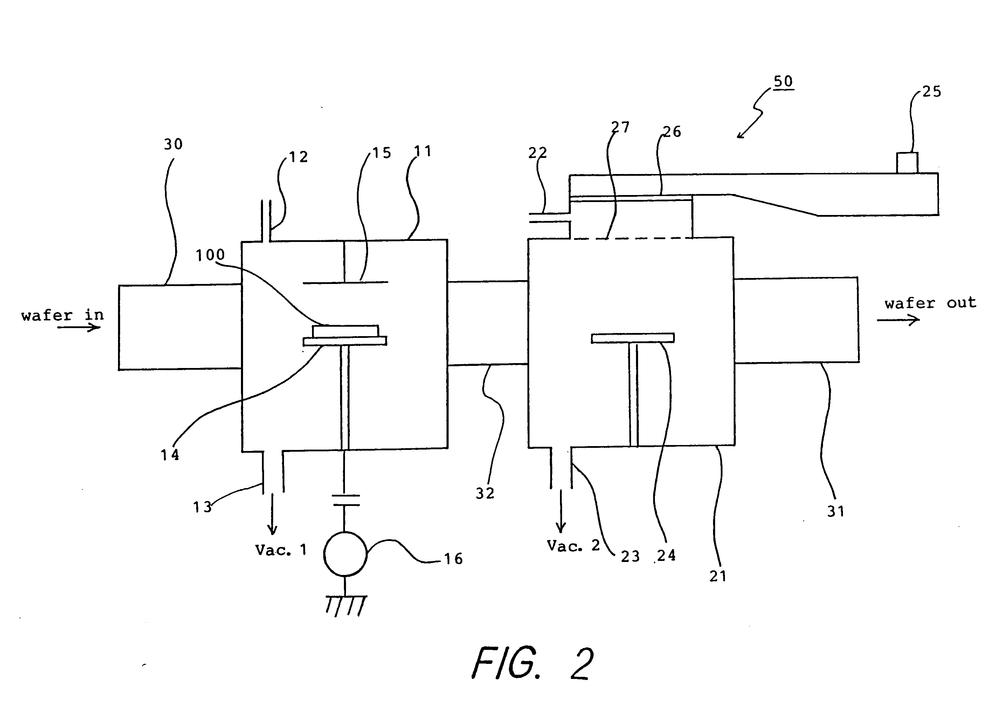

Next, the resist layer 2 is removed, and in this embodiment of the present invention, this removal is performed in two steps respectively for removing the carbonized region 2a and the uncarbonized region 2b, using a resist ashing apparatus 50. Fig. 2 is a schematic illustration of the resist ashing apparatus 50. As shown in Fig. 2, the resist ashing apparatus 50 consists of a cathode-coupled parallel plate plasma ashing chamber 11, which will be called simply a "plasma ashing chamber 11" hereinafter, for removing the carbonized region 2a, a downstream ashing chamber 21 for removing the uncarbonized region 2b, and load locks or blocks 30, 31 and 32. The load lock 30 is for introducing a wafer to the plasma ashing chamber 11 from outside the resist ashing apparatus 50, the load lock 32 is for transferring the wafer from the plasma ashing chamber 11 to the downstream ashing chamber 21, and the load lock 31 is for outputting the wafer from the downstream ashing chamber 21 to the outside. Here, a wafer is a member such as a silicon wafer divided into a plurality of semi-processed devices on each of which a resist layer is formed.

In the plasma ashing chamber 11, plasma is confined between a power electrode 15 and a table 14 on which a wafer 100 is placed; wherein, on the wafer 100, a plurality of semi-processed devices as seen in Fig. 1(b) are provided. The temperature of the wafer 100 can be controlled by a heater and a cooler, not shown in Fig. 2, attached to the table 14. RF (radio frequency) power at 13.56 MHz is delivered to the plasma from a power source 16. The temperature of the wafer 100 should be maintained lower than a softening point (about 120°C) of the resist layer 2. If the temperature were to exceed the softening point (for a prolonged period), the uncarbonized region 2b would be softened during the etching of the carbonized region 2a, so that the carbonized region 2a could suffer cracking and be torn or divided into many pieces, with some pieces sunk into the softened uncarbonized region 2b. As a result, residues obtained from plasma etching of the carbonized region 2a would be left at the bottom of the uncarbonized region 2b adhering to the upper surface of the substrate 1, unless the residues are etched off by the plasma. If plasma etching were applied to the uncarbonized region 2b, the same problems as have previously occurred would arise.

A mixed gas composed of 97% nitrogen and 3% hydrogen in volume is used in the plasma ashing chamber 11 as a reactive gas, with, for instance, a pressure of 66.7 Pa (0.5 Torr). The mixed gas is introduced into the plasma ashing chamber 11 through an inlet 12 and exhausted from the plasma ashing chamber 11 through an outlet 13, using an evacuating system Vac. 1 not shown in Fig. 2.

When plasma etching is performed on resist layer 2 formed on (the semi-processed devices on) the wafer 100, in other words, formed on substrate 1, with the gas in the plasma ashing chamber 11, an upper region, for example 1 $\mu$m thick, of the resist layer 2 is etched off, so that the carbonized region 2a is completely etched, leaving a lower region 2c of the resist layer 2, as shown in Fig. 1-(c).

After removing the carbonized region 2a, the lower region 2c is removed in the next step. In this next step, the wafer 100 on the table 14 in the plasma ashing chamber 11 is transferred to a table 24 in the downstream ashing chamber 21 through the load block 32 without breaking the vacuum in the apparatus, and the lower region 2c is removed in the downstream ashing chamber 21, applying a downstream ashing method.

In the downstream ashing chamber 21, a microwave plasma is generated by a magnetron source 25 oscillating RF at 2.45 GHz and confined in a space between a window 26 and a shower head 27. Meanwhile, a mixed gas composed of 97% (in volume) oxygen and 3% tetrafluoromethane is introduced through an inlet 22 and exhausted to an evacuating system Vac. 2, not shown in Fig. 2, through an outlet 23. Consequently, the wafer 100 is etched in a space between the shower head 27 and the table 24 filled with oxygen and other gas species being neutral in atomic state. This kind of etching is called downstream ashing, and by this etching the lower region 2c is completely removed as shown in Fig. 1(d). The power required to perform the downstream ashing is lower, compared to that of the plasma ashing performed in the chamber 11, so that problems do not arise in respect of the substrate 1 as they have previously done.

Other methods can be used for etching the lower region 2c, for example a wet stripping method. However, when the wet stripping method is used, substrate 1 (wafer 100) must be taken out of chamber 11, breaking the vacuum, after the plasma etching of the upper region 2a.

Using a method embodying the present invention for removing resist layer 2, almost no residue remains on the surface of the substrate 1. For evaluating how satisfactorily the resist layer 2 is removed, a particle counter for counting the number of the residues, such as phosphorus oxides, heavy metals and carbon compounds, remaining on the surface of the subsrate 1 is employed. Counting only residues having diameters larger than 100 $\mu$m, the number of residues present after use of an embodiment of this invention is 300 to 350 per 10.16-cm (4-inch) wafer for instance. This number is very small, compared with residue numbers previously achieved. That is, when an oxygen plasma etching method is used for removing the resist layer 2, the residue number is about 8000 per 10.16-cm (4-inch) wafer. It is clear that the present invention can provide for remarkable improvement in relation to the removal of an ion-implanted resist layer.

Although an ashing process in accordance with an embodiment of the present invention can generate a few lattice defects, the lattice defects can be eliminated by annealing the substrate 1 at a temperature higher than 400°C.

An embodiment of the present invention provides a method for removing a resist layer, in which a high dose of ions has been implanted, by etching in two steps:- in a first step, a carbonized region produced in the resist layer due to the high dose ion implantation is etched by applying plasma using hydrogen as a reactive gas at a temperature lower than a softening point of the resist layer; and in the second step, a lower region of the resist layer, left after the etching of the first step, is etched by a method such as a downstream ashing method or a wet stripping method.

## Claims

1. A method of removing a resist layer (2) formed on a substrate (1), the resist layer (2) including an ion-implanted region (2a), extending into the resist layer from an upper surface of the resist layer (2), into which a high dose of ions has been implanted and which has suffered carbonization, the method comprising:-

   removing a first region of the resist layer (2), including the said ion-implanted region (2a) which has suffered carbonization, by a first plasma etching process, using hydrogen as a reactive gas, the hydrogen reacting with the dopant implanted in the resist layer, producing volatile hydrogenated compounds, leaving a second region (2c) of the resist layer (2) in place, which second region (2c) has not suffered carbonization; and

   removing the second region (2c) by a second etching process performed without using a plasma having charged particles.

2. A method as claimed in claim 1, wherein the second etching process is a downstream etching process.

3. A method as claimed in claim 1, wherein the second etching process is a wet stripping process.

4. A method as claimed in claim 1, 2 or 3, wherein the first etching process is performed at a temperature lower than a softening point of the resist layer (2).

5. A method as claimed in claim 1, 2, 3 or 4, wherein the removal of the first region is performed using a mixed gas including said hydrogen and an inert gas, for example nitrogen.

6. A method as claimed in any preceding claim, further comprising annealing the substrate (1) at a temperature higher than 400°C, after removal of the resist layer (2).

7. A method as claimed in claim 5, wherein the first etching process is performed in a parallel plate plasma etching chamber filled with the mixed gas.

## Patentansprüche

1. Verfahren zur Entfernung einer auf einem Substrat (1) gebildeten Resistschicht (2), wobei die Resistschicht (2) eine ionenimplantierte Zone (2a) enthält, welche sich in die Resistschicht von einer Oberseitenfläche der Resistschicht (2) erstreckt, in die eine hohe Ionendosis implantiert wurde, und die eine Carbonisierung erfahren hat, welches Verfahren umfaßt:

   Entfernen einer ersten Zone der Resistschicht (2), welche die genannte ionenimplantierte Zone (2a) enthält, die eine Carbonisierung erfahren hat, durch ein erstes Plasmaätzverfahren unter Verwendung von Wasserstoff als reaktives Gas, wobei der Wasserstoff mit dem in der Resistschicht implantierten Dotierungsstoff reagiert, flüchtige hydrierte Verbindungen erzeugend, und eine zweite Zone (2c) der Resistschicht (2) an ihrer Stelle belassen wird, welche zweite Zone (2c) keine Carbonisierung erfahren hat; und

   Entfernen der zweiten Zone (2c) durch ein zweites Ätzverfahren, welches ohne Verwendung eines Plasmas mit geladenen Teilchen durchgeführt wird.

2. Verfahren nach Anspruch 1, bei welchem das zweite Ätzverfahren ein stromabwärtiges Ätzverfahren ist.

3. Verfahren nach Anspruch 1, bei welchem das zweite Ätzverfahren ein Naßabstreifverfahren ist.

4. Verfahren nach Anspruch 1, 2 oder 3, bei welchem das erste Ätzverfahren bei einer Temperatur unter dem Erweichungspunkt der Resistschicht (2) durchgeführt wird.

5. Verfahren nach Anspruch 1, 2, 3 oder 4, bei welchem die Entfernung der ersten Zone unter Verwendung eines gemischten Gases durchgeführt wird, das den genannten Wasserstoff und ein inertes Gas, beispielsweise Stickstoff, enthält.

6. Verfahren nach einem der vorhergehenden Ansprüche, ferner umfassend das Ausheilen des Substrats (1) bei einer Temperatur von mehr als 400°C nach der Entfernung der Resistschicht (2).

7. Verfahren nach Anspruch 5, bei welchem das erste Ätzverfahren in einer mit dem gemischten Gas gefüllten Parallelplatten-Plasmaätzkammer durchgeführt wird.

## Revendications

1. Procédé pour retirer une couche de résine photosensible (2) formée sur un substrat (1), la couche de résine photosensible (2) comprenant une région (2a) ayant subi une implantation ionique qui s'étend dans la couche de résine photosensible depuis une surface supérieure de la couche de résine photosensible (2), dans laquelle une forte dose d'ions a été implantée et qui a subi une carbonisation, le procédé comprenant :

le retrait d'une première région de la couche de résine photosensible (2) comprenant ladite région (2a) ayant subi une implantation ionique qui a subi la carbonisation, par un premier processus d'attaque au plasma, utilisant l'hydrogène comme gaz réactif, l'hydrogène réagissant avec le dopant implanté dans la couche de résine photosensible en produisant des composés hydrogénés volatils, en laissant en place une seconde région (2c) de la couche de résine photosensible (2) qui n'a pas subi la carbonisation, et

le retrait de la seconde région (2c) par un second processus d'attaque mis en oeuvre sans utilisation d'un plasma contenant des particules chargées.

2. Procédé selon la revendication 1, dans lequel le second processus d'attaque est un processus d'attaque en aval.

3. Procédé selon la revendication 1, dans lequel le second processus d'attaque est un processus de décapage humide.

4. Procédé selon la revendication 1, 2 ou 3, dans lequel le premier processus d'attaque est accompli à une température inférieure au point de ramollissement de la couche de résine photosensible (2).

5. Procédé selon la revendication 1, 2, 3 ou 4, dans lequel le retrait de la première région est accompli à l'aide d'un mélange gazeux comprenant ledit hydrogène et un gaz inerte, par exemple l'azote.

6. Procédé selon l'une quelconque des revendications précédentes, comprenant en outre lé recuit du substrat (1) à une température supérieure à 400°C après le retrait de la couche de résine photosensible (2).

7. Procédé selon la revendication 5, dans lequel le premier processus d'attaque est accompli dans une chambre d'attaque au plasma à plaques parallèles remplie du mélange gazeux.

FIG. 1 (a)

FIG. 1 (b)

FIG. 1(c)

FIG. 1 (d)

wafer in →

wafer out →

Vac. 1

Vac. 2

30   12   15   11   100   14   13   16   32   22   27   26   50   25   23   24   21   31

*FIG. 2*

EP 0 304 068 B1

8